(19) Europäisches Patentamt
European Patent Office
Office européen des brevets

(11) **EP 4 319 503 A1**

(12) **EUROPEAN PATENT APPLICATION**
published in accordance with Art. 153(4) EPC

(43) Date of publication:
**07.02.2024 Bulletin 2024/06**

(21) Application number: **21933255.8**

(22) Date of filing: **10.12.2021**

(51) International Patent Classification (IPC):
**H05K 1/09** (2006.01)     **B22D 19/00** (2006.01)
**C04B 37/02** (2006.01)     **C22C 21/00** (2006.01)
**H01L 23/14** (2006.01)     **H05K 1/02** (2006.01)

(52) Cooperative Patent Classification (CPC):
**B22D 19/00; C04B 37/02; C22C 21/00;
H01L 23/14; H05K 1/02; H05K 1/09**

(86) International application number:
**PCT/JP2021/045567**

(87) International publication number:
**WO 2022/201662 (29.09.2022 Gazette 2022/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.03.2021 JP 2021048815**

(71) Applicant: **Dowa Metaltech Co., Ltd.
Tokyo 101-0021 (JP)**

(72) Inventor: **KOBAYASHI, Koji
Tokyo 101-0021 (JP)**

(74) Representative: **Müller-Boré & Partner
Patentanwälte PartG mbB
Friedenheimer Brücke 21
80639 München (DE)**

(54) **ALUMINUM-CERAMIC BONDED SUBSTRATE AND MANUFACTURING METHOD THEREFOR**

(57) There is provided an aluminum-ceramic bonded substrate in which an aluminum plate comprising aluminum alloy is directly bonded to one surface of a ceramic substrate and an aluminum base plate comprising aluminum alloy is directly bonded to the other surface of the ceramic substrate, wherein the aluminum alloy is the aluminum alloy containing 0.05% by mass or more and 3.0% by mass or less of at least one element selected from nickel and iron in total amount, containing 0.01% by mass or more and 0.1% by mass or less of at least one element selected from titanium and zirconium in total amount, and containing 0% by mass or more and 0.05% by mass or less of at least one element selected from boron or carbon in total amount, with a balance being aluminum.

**FIG. 1**

100

14
12
10

10: Aluminum base plate
12: Ceramic substrate
14: Circuit pattern aluminum plate
100: Aluminum-ceramic bonded substrate

**Description**

Background

Technical Field

The present invention relates to an aluminum-ceramic bonded substrate and a method for manufacturing the same, and particularly, relates to an aluminum-ceramic bonded substrate in which an aluminum member comprising aluminum alloy is bonded to a ceramic substrate, and a method for manufacturing the same.

Related Art

In fields such as electric vehicles and machine tools, an aluminum-ceramic bonded substrate in which an aluminum member is bonded to a ceramic substrate, is used as an insulating substrate for highly reliable power modules that control large currents.

Patent document 1 discloses an aluminum-ceramic bonded substrate manufactured by setting a ceramic substrate in a mold, then, pouring a molten aluminum-silicon alloy containing 0.1 to 1.5% by weight of silicon and 0.03 to 0.10% by weight of boron into the mold so as to be in contact with at least one surface of the ceramic substrate, then, cooling and solidifying the molten aluminum-silicon alloy, and directly contacting and bonding an aluminum alloy member to the ceramic substrate. Patent document 1 also discloses that in the aluminum-ceramic bonded substrate thus produced, crystal grains of the aluminum-silicon alloy of the aluminum alloy member bonded to the ceramic substrate, can be made finer.

Patent document 2 discloses an aluminum-ceramic bonded substrate in which an aluminum alloy plate comprising aluminum alloy is bonded to a ceramic substrate by a molten metal bonding method, the aluminum alloy plate containing 0.1 to 1.5% by weight of silicon, 0.02 to 0.1% by weight of boron, 0.005 to 0.2% by weight of iron, 0.005 to 0.3% by weight of one or more elements selected from the group consisting of zinc, copper, silver and magnesium, and 0.001 to 0.05% by weight of one or more elements selected from the group consisting of titanium, vanadium and manganese. Thereby, it is possible to provide the aluminum-ceramic bonded substrate in which the crystal grains of the aluminum alloy can be made finer to increase the grain boundaries, the precipitation of the aluminum-boron compound can be suppressed, good etching can be performed, and plating properties can be improved.

Patent document 3 discloses an insulating substrate for semiconductor mounting in which a metal layer containing silicon, copper, zinc or nickel, mainly composed of aluminum, is formed on at least a part of a surface of a ceramic substrate, the metal layer having Vickers hardness of 25 or more and less than 40, having a silicon content of 0.2% by weight or more and less than 5% by weight, and the ceramic substrate being one selected from alumina, aluminum nitride, and silicon nitride. Here, the metal layer may have the copper content of 0.2% by weight or more and less than 3% by weight, the zinc content of 0.2% by weight or more and less than 3% by weight, the nickel content of 0.2% by weight or more and less than 3% by weight. Patent document 3 also discloses that use of such an aluminum-ceramic insulating substrate, which is an insulating substrate for semiconductor mounting, prevents deterioration of thermal shock resistance due to cracks at a joint interface with solder caused by deformation of aluminum due to thermal shock.

Patent document 4 discloses an aluminum-ceramic bonded substrate and a method for manufacturing the same as follows: when the aluminum plate is directly bonded to a ceramic substrate by pouring molten aluminum so as to come into contact with the ceramic substrate placed in the mold and cooling and solidifying the molten aluminum, an additive such as a TiB alloy, Ca or Sr is added to the molten aluminum to suppress the decrease in the thermal conductivity of an aluminum plate to within 20% of the thermal conductivity of a pure aluminum plate, and make the crystal grain size of the aluminum plate 10 mm or less. With this configuration, by reducing the crystal grain size of aluminum, it is possible to reduce a variation in a crystal grain size distribution and prevent cracks from occurring in the ceramic substrate after heat cycles, and it is possible to control warping of an aluminum base plate due to heating when soldering a semiconductor chip, etc., and suppress the deterioration of heat dissipation when heat dissipation fins are attached to the aluminum base plate.

Prior Art Document

Patent Document

[Patent Document 1] JP-A-2005-252136
[Patent Document 2] JP-A-2007-92150

[Patent Document 3] JP-A-2002-329814
[Patent Document 4] JP-A-2005-103560

In recent years, due to the use of SiC semiconductor chips, etc., an aluminum-ceramic bonded substrate with excellent heat cycle resistance that is durable even in heat cycles at a temperature as high as 150°C, has come to be required. However, in the aluminum-ceramic bonded substrates according to Patent Documents 1 to 4, for example, a high-temperature heat cycle test reveals that after 500 heat cycles, a surface roughness of a circuit pattern increases, cracks may occur in the chip soldered to the circuit pattern of the bonded board, or cracks may occur in a solder layer.

The present invention was made under such circumstances, and an object of the present invention is to provide an aluminum-ceramic bonded substrate in which an aluminum plate comprising aluminum alloy is directly bonded to one surface of a ceramic substrate, and an aluminum plate comprising aluminum alloy is directly bonded to the other surface, having excellent heat cycle resistance and durability such that an increase in surface roughness of a circuit pattern is suppressed even in high-temperature heat cycles, and a method for manufacturing the same.

That is, in order to solve the above-described problem, a first invention provides an aluminum-ceramic bonded substrate in which an aluminum plate comprising aluminum alloy is directly bonded to one surface of a ceramic substrate and an aluminum base plate comprising aluminum alloy is directly bonded to the other surface of the ceramic substrate, wherein the aluminum alloy is the aluminum alloy containing 0.05% by mass or more and 3.0% by mass or less of at least one element selected from nickel and iron in total amount, containing 0.01% by mass or more and 0.1% by mass or less of at least one element selected from titanium and zirconium in total amount, and containing 0% by mass or more and 0.05% by mass or less of at least one element selected from boron or carbon in total amount, with a balance being aluminum.

A second invention provides the aluminum-ceramic bonded substrate according to the first invention, wherein the aluminum plate has a Vickers hardness HV of 17 or more.

A third invention provides the aluminum-ceramic bonded substrate according to the first or second invention, wherein the aluminum plate has a Vickers hardness HV of less than 25.

A fourth invention provides the aluminum-ceramic bonded substrate according to any one of the first to third inventions, wherein an average crystal grain size in a surface of the aluminum plate is 600 $\mu$m or less.

A fifth invention provides the aluminum-ceramic bonded substrate according to any one of the first to fourth inventions, wherein the surface of the aluminum plate has an arithmetic mean roughness Ra of 1.0 $\mu$m or less.

A sixth invention provides the aluminum-ceramic bonded substrate according to any one of the first to fifth inventions, wherein the aluminum plate has an electrical resistivity of 3.2 $\mu\Omega\cdot$cm or less.

A seventh invention provides the aluminum-ceramic bonded substrate according to any one of the first to sixth inventions, wherein a main component of the ceramic substrate is one or more selected from alumina, aluminum nitride, silicon nitride and silicon carbide.

An eighth invention provides the aluminum-ceramic bonded substrate according to any one of the first to seventh inventions, wherein a plate-like reinforcing member having hardness greater than that of the aluminum base plate is arranged inside the aluminum base plate and directly bonded to the aluminum base plate.

A nineth invention provides a method for manufacturing an aluminum-ceramic bonded substrate, comprising:

placing a ceramic substrate in a mold, and pouring molten aluminum alloy into the mold so as to be in contact with both sides of the ceramic substrate, followed by cooling and thereby,
forming an aluminum plate comprising the aluminum alloy on one surface of the ceramic substrate and directly bonding it to the ceramic substrate; and
forming an aluminum base plate comprising the aluminum alloy on the other surface of the ceramic substrate and directly bonding it to the ceramic sub strate,
wherein the aluminum alloy is the aluminum alloy containing 0.05% by mass or more and 3.0% by mass or less of at least one element selected from nickel or iron in total amount, containing 0.01% by mass or more and 0.1% by mass or less of at least one element selected from titanium or zirconium in total amount, and containing 0% by mass or more and 0.05% by mass or less at least one element selected from boron or carbon in total amount, with a balance being aluminum.

A tenth invention provides the method for manufacturing an aluminum-ceramic bonded substrate according to the ninth invention, wherein a main component of the ceramic substrate is one or more selected from alumina, aluminum nitride, silicon nitride and silicon carbide.

An eleventh invention provides the method for manufacturing an aluminum-ceramic bonded substrate according to the ninth or tenth invention, including:

placing a plate-like reinforcing member in the mold at a distance from the ceramic substrate, pouring the molten aluminum alloy into the mold so as to be in contact with both surfaces of the ceramic substrate in the mold and a surface of the reinforcing member, followed by cooling and thereby,

forming the aluminum plate comprising the aluminum alloy on one surface of the ceramic substrate and directly bonding it to the ceramic substrate;

forming the aluminum base plate comprising the aluminum alloy on the other surface of the ceramic substrate and directly bonding it to the ceramic substrate; and

placing the reinforcing member inside the aluminum base plate and directly bonding it to the aluminum base plate.

Advantage of the Invention

According to the present invention, there is provided an aluminum-ceramic bonded substrate in which an aluminum plate comprising aluminum alloy is directly bonded to one surface of a ceramic substrate and an aluminum base plate comprising aluminum alloy is directly bonded to the other surface of the ceramic substrate, having excellent heat cycle resistance and durability such that an increase in surface roughness of a circuit pattern is suppressed even in high-temperature heat cycles, and a method for manufacturing the same.

Brief description of the drawings

FIG. 1 is a schematic plan view of one example of an aluminum-ceramic bonded substrate according to the present invention.
FIG. 2 is a cross-sectional view taken along line II-II of FIG. 1.
FIG. 3 is a schematic cross-sectional view of one example of a mold used for manufacturing an aluminum-ceramic bonded substrate according to the present invention.

Detailed description of the invention

Embodiments of the present invention will be described in an order of 1. Aluminum-ceramic bonded substrate; 2. Various properties of aluminum-ceramic bonded substrate; 3. Method for manufacturing aluminum-ceramic bonded substrate.

1. Aluminum-ceramic bonded substrate

An aluminum-ceramic bonded substrate according to the present invention will be described in an order of (1) Structure, (2) Aluminum alloy, (3) Ceramic substrate, (4) Reinforcing member.

(1) Structure

The structure of the aluminum-ceramic bonded substrate according to the present invention will be briefly described with reference to the drawings.

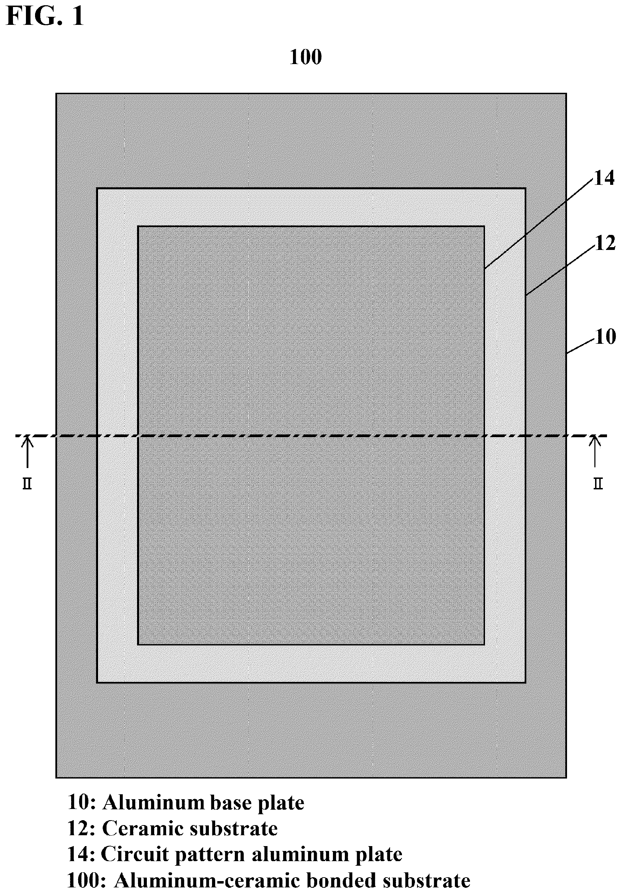

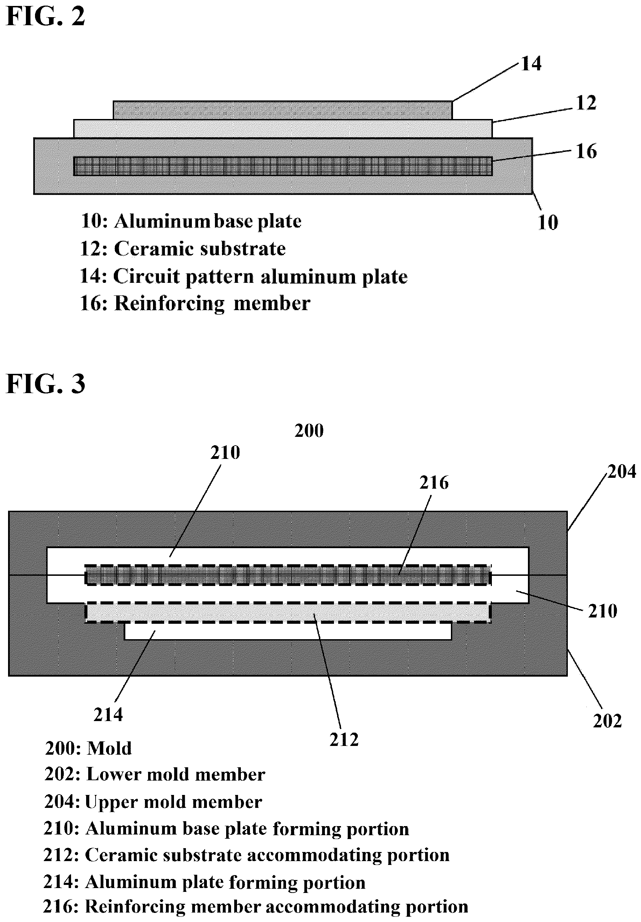

FIG. 1 is a plan view of one example of an aluminum-ceramic bonded substrate according to the present invention, and FIG. 2 is a sectional view taken along the line II-II of FIG. 1.
As shown in FIGS. 1 and 2, an aluminum-ceramic bonded substrate 100 according to the present invention includes: an aluminum base plate 10 (having a substantially rectangular planar shape in the illustrated embodiment) comprising aluminum alloy; a ceramic substrate 12 (having a substantially rectangular planar shape in the illustrated embodiment) whose one surface is directly bonded to the aluminum base plate 10; one or more (one in FIG. 1) circuit pattern aluminum plates 14 (having a substantially rectangular planar shape in the illustrated embodiment) comprising aluminum alloy directly bonded to the other surface of the ceramic substrate 12.

(2) Aluminum alloy

The above-described aluminum alloy is aluminum alloy (Al-(Ni, Fe)-(Ti, Zr) alloy) containing 0.05% by mass or more and 3.0% by mass or less, preferably 0.1% by mass or more and 2.5% by mass or less (further 1.5% by mass % or less) of at least one element selected from nickel or iron in total amount, and contains 0.01% by mass or more and 0.1% by mass or less, preferably 0.02% by mass or more and 0.08% by mass or less (further 0.06% by mass or less) ) of at least one element selected from titanium or zirconium in total amount, and contains 0% by mass or more and 0.05% by mass or less, preferably 0.001% by mass or more and 0.02% by mass or less of at least one element selected from boron or carbon in total amount, with a balance being aluminum.

The aluminum alloy in the present invention may contain unavoidable impurity elements that are unavoidably mixed from a raw material or the like, and small amounts of other elements within a range where the effects of the present invention are exhibited. A total amount of the inevitable impurity elements and the other elements is preferably 0.5% by mass or less, more preferably 0.3% by mass or less, and may be 0.1% by mass or less.

Further, the aluminum alloy forming the aluminum base plate 10 and the aluminum alloy forming the circuit pattern aluminum plate 14 may have the same composition or different compositions, as desired.

The aluminum alloy according to the present invention is durable even in high-temperature heat cycles, which will be described later in "2. Various properties of aluminum-ceramic bonded substrate", and can suppress an increase in surface roughness of the circuit pattern even after adding predetermined heat cycles. Further, well-balanced and excellent properties are exhibited in various properties of the aluminum-ceramic bonded substrates such as electrical conductivity, hardness, surface roughness, and average grain size.

Next, elements contained in the aluminum alloy will be described in an order of (I) nickel, iron, (II) titanium, zirconium, and (III) boron and carbon.

(I) nickel, iron

The hardness (strength) can be improved (compared to pure aluminum) by adding nickel and iron, which are additive elements, to aluminum. On the other hand, the decrease in electrical conductivity and thermal conductivity can be suppressed to be relatively small.

When the aluminum alloy contains an element selected from nickel or iron, or when both nickel and iron elements are contained, the hardness (strength) of aluminum can be sufficiently improved by their total content of 0.05% by mass or more. Further, electrical conductivity and thermal conductivity can be sufficiently ensured when their total content is 3.0% by mass or less. From this point of view, the total content is preferably 0.1% by mass or more and 2.5% by mass or less (more preferably 1.5% by mass or less).

(II) titanium, zirconium

By adding titanium and zirconium, which are additive elements, to aluminum, the crystal grain size of the circuit pattern aluminum plate and the aluminum base plate can be made finer. Then, such a fine crystal grain size is advantageous from a viewpoint of improving heat cycle resistance. Further, it is conceivable that titanium and zirconium form an intermetallic compound with nickel and iron, thereby improving the strength of the aluminum alloy.

Further, by making such an alloy composition, changes in the arithmetic mean roughness Ra of the surfaces of the aluminum plate and the aluminum base plate can be suppressed to be small, and the heat cycle resistance can be improved, for example, even when performing a high temperature heat cycle test at 150°C on the high temperature side.

When the aluminum alloy contains one element selected from titanium or zirconium, or when both elements of titanium and zirconium are contained in the total content of 0.01% by mass or more, the crystal grain size of the circuit pattern aluminum plate and the aluminum base plate can be made small. Further, when the total content is 0.1% by mass or less, electrical conductivity can be sufficiently ensured. From this point of view, the total content is preferably 0.02% by mass or more and 0.08% by mass or less (more preferably 0.06% by mass or less).

(III) boron, carbon

If one element selected from titanium or zirconium described above is added alone when producing an aluminum alloy, for example, it may be difficult to control the composition to a predetermined composition due to oxidation loss and the like. In such a case, for example, titanium is preferably added in the form of a master alloy such as an Al-Ti-B alloy. Accordingly, although boron and carbon are optional elements (does not have to be added), at least one element selected from boron or carbon may be contained in total amount of 0% by mass or more and 0.05% by mass or less, and it is also preferable to contain 0.001% by mass or more and 0.04% by mass or less (furthermore, 0.002% by mass or more and 0.02% by mass or less).

(3) Ceramic substrate

The ceramic substrate has a function of maintaining insulation between an "aluminum circuit boards" to be described in examples and between the circuit pattern aluminum plate and the aluminum base plate. Then, the ceramic substrate preferably comprises one or more selected from alumina, aluminum nitride, silicon nitride and silicon carbide as a main component (85% by mass or more as composition).

(4) Reinforcing member

If desired, the aluminum base plate can include a plate-like reinforcing member. The reinforcing member will be described with reference to FIGS. 1 and 2.

Inside the aluminum base plate 10, the main surface (plate surface) of the plate-like reinforcing member 16 (having a substantially rectangular planar shape in the illustrated embodiment) is arranged on a (virtual) plane substantially parallel to a surface of the aluminum base plate 10 bonded to the ceramic substrate 12, and the surface of the reinforcing member 16 can be directly bonded to the aluminum base plate 10.

As described above, the reinforcing member 16 is a member provided as desired in the present invention, and is a plate-like member having a higher hardness (strength) than the aluminum base plate 10. By arranging the reinforcing member 16 inside the aluminum base plate 10, it is possible to reduce a warpage and unevenness of the aluminum-ceramic bonded substrate 100, especially the warpage and unevenness in a longitudinal direction, which is preferable.

Further, with a configuration in which the reinforcing member 16 is directly bonded to the aluminum base plate 10, bonding defects can be suppressed, and the ceramic substrate 12 and the reinforcing member 16 can be simultaneously bonded to the aluminum alloy, which is also preferable from a viewpoint of a manufacturing cost.

The reinforcing member 16 preferably comprises metal or ceramics having a higher melting point than the aluminum alloy forming the aluminum base plate. From this point of view, the reinforcing member is preferably one or more selected from alumina, aluminum nitride, silicon nitride and silicon carbide.

2. Various properties of aluminum-ceramic bonded substrate

Various properties of the aluminum-ceramic bonded substrate will be described in an order of (1) electrical conductivity, (2) hardness, and (3) surface roughness and average crystal grain size.

In the present invention, conditions of "-40°C $\times$ 30 minutes $\rightarrow$ 25°C $\times$ 10 minutes $\rightarrow$ 150°C $\times$ 30 minutes $\rightarrow$ 25°C $\times$ 10 minutes" are one cycle in a mode of the high temperature heat cycle test.

(1) Electrical conductivity

In the aluminum-ceramic bonded substrate 100, since the circuit pattern aluminum plate is required to have high electrical conductivity, electrical resistivity is preferably 3.2 $\mu\Omega\cdot$cm or less, more preferably 3.0 $\mu\Omega\cdot$cm or less.

(2) Hardness

Vickers hardness HV of the surface of the circuit pattern aluminum plate and aluminum base plate is important, from a viewpoint of fastness between the aluminum-ceramic bonded substrate 100 and a cooler, and deformation resistance when the aluminum-ceramic bonded substrate is subjected to heat cycles. From this point of view, initial Vickers hardness HV (before adding a high-temperature heat cycle) is preferably 17 or more and less than 25, more preferably 18 or more and 24 or less.

The aluminum-ceramic bonded substrate 100 is assembled into a module such as a power module. When assembling, the aluminum base plate 10 is fastened to a cooling plate for heat dissipation, cooling jacket, case member (casing) covering semiconductor parts on the circuit side, etc., (not shown) with screws or bolts through holes provided in the aluminum base plate 10 (not shown). At this time, when the Vickers hardness HV is 17 or more, it is possible to avoid a gap between the aluminum base plate 10 and a cooling plate due to the deformation of the aluminum base plate 10, and loosening of the screws and bolts when a high-temperature heat cycle is applied.

On the other hand, for example, when the initial Vickers hardness HV of the aluminum base plate 10 (before the heat cycle test) is less than 25, it is possible to avoid an occurrence of cracks in the ceramic substrate 12 after 500 cycles in the high temperature heat cycle test. Therefore, even after 500 cycles in the high temperature heat cycle test, the Vickers hardness HV is preferably 29 or less, more preferably 27 or less, even more preferably 25 or less.

In the aluminum alloy of the present invention, an initial Vickers hardness (before heat cycle) of the aluminum base plate is 17 or more, and change (increase) in hardness is small even when heat cycles are applied, and hardness can be maintained at 27 or less even after 500 cycles, and therefore it is possible to suppress an occurrence of cracks in the ceramic substrate 12 due to thermal stress caused by a difference in thermal expansion, which contributes to improving the heat cycle resistance of the aluminum-ceramic bonded substrate 100.

(3) Surface roughness, average crystal grain

When the high-temperature heat cycle is applied to the circuit pattern aluminum plate 14 as a circuit pattern, with a semiconductor chip (not shown) joined using solder, etc., and if the initial arithmetic mean roughness Ra on the surface of the circuit pattern aluminum plate 14 (before adding a high-temperature heat cycle) is too large, large steps (convex portions) are formed on the surface of the circuit pattern aluminum plate 14 after adding high-temperature heat cycles, and the semiconductor chip may crack or cracks may occur in the solder layer.

To avoid such a situation, the arithmetic mean roughness Ra of the surface of the circuit pattern aluminum plate 14 is preferably 1.0 $\mu$m or less at an initial stage (before adding a high-temperature heat cycle), further, it is preferably 1.0 $\mu$m or less even after 400 or even 500 high-temperature heat cycles are applied.

In the aluminum alloy according to the present invention, even when the high-temperature heat cycle is applied, the change (increase) in the arithmetic mean roughness Ra can be suppressed, and a large step is not formed on the surface of the circuit pattern aluminum plate 14.

Further, it is preferable that the average grain size of the surface of the circuit pattern aluminum plate 14 is 600 $\mu$m or less at the initial stage (before adding high temperature heat cycles), from a viewpoint of avoiding the formation of the large steps (convex portion) described above. In the aluminum alloy according to the present invention, the crystal grain size can be made finer to 600 $\mu$m or less (preferably 500 $\mu$m or less, 100 $\mu$m or more), and there is an effect of improving heat cycle resistance.

It is desirable that the surface roughness of the back surface of the aluminum base plate 10 (the surface to which the ceramic substrate 12 is not bonded) is also kept within a predetermined range. Since the back surface of the aluminum base plate 10 is attached to a cooling plate for heat dissipation, there is a possibility that the adhesion may be lowered if the surface roughness is too large. To avoid such a situation, the arithmetic mean roughness Ra of the back surface of the aluminum base plate 10 is preferably 1.5 $\mu$m or less at the initial stage (before adding high temperature heat cycles), and is preferably 1.5 $\mu$m or less (further, 1.0 $\mu$m or less) even after 500 high-temperature heat cycles.

3. Method for manufacturing aluminum-ceramic bonded substrate

An example of a method for manufacturing the aluminum-ceramic bonded substrate 100 according to the present invention will be described.

First, the ceramic substrate 12 and the reinforcing member 16 are spaced apart from each other in a mold. Then, the molten aluminum alloy according to the present invention is poured into the mold so as to be in contact with both surfaces of the ceramic substrate 12 and the surface of the reinforcing member 16 followed by cooling and thereby, the circuit pattern aluminum plate 14 comprising aluminum alloy is formed on one surface of the ceramic substrate 12 and directly bonded to the ceramic substrate 12. On the other hand, the aluminum base plate 10 comprising aluminum alloy is formed on the other surface of the ceramic substrate 12 and directly bonded to the ceramic substrate 12, and the reinforcing member 16 is arranged so as to be surrounded by the aluminum base plate 10 and directly bonded to the inside of the aluminum base plate 10.

As described above, the aluminum-ceramic bonded substrate 100 according to the present invention can be manufactured.

Next, the mold used for manufacturing the aluminum-ceramic bonded substrate 100 will be described more specifically with reference to FIG. 3, which is a schematic cross-sectional view of one example of the mold used for manufacturing the aluminum-ceramic bonded substrate 100 according to the present invention.

The mold 200 is composed of a lower mold member 202 having a substantially rectangular planar shape and an upper mold member 204 placed on the lower mold member 202 to form a mold. An aluminum base plate forming portion 210 for forming an aluminum base plate is formed on the upper surface of the lower mold member 202. One or more (FIG. 3 shows the case of only one) recesses (ceramic substrate accommodating portion 212 for accommodating a ceramic substrate) having substantially the same shape and size as the ceramic substrate are formed on the bottom surface of the aluminum base plate forming portion 210. One or more (FIG. 3 shows the case of only one) recesses (circuit pattern aluminum plate forming portion 214 for forming an aluminum plate) having substantially the same shape and size as the circuit pattern aluminum plate, are formed on the bottom surface of the ceramic substrate accommodating portion 212.

The aluminum base plate forming portion 210 is formed on the bottom surface of the upper mold member 204 (the surface facing the lower mold member 202), and when the upper mold member 204 is placed over the lower mold member 202, the space of the aluminum base plate forming portion 210 is defined, together with the aluminum base plate forming portion 210 of the lower mold member 202. Further, the upper mold member 204 is formed with a pouring port for pouring molten metal from a pouring nozzle (not shown) into the aluminum base plate forming portion 210 in the mold 200.

In addition, a molten metal flow path (not shown) for supplying molten metal is also formed in the circuit pattern aluminum plate forming portion 214 of the lower mold member 202, and the molten metal can be supplied to the aluminum plate forming portion 214 even when the ceramic substrate is accommodated in the ceramic substrate accommodating portion 212.

Further, the reinforcing member can be formed in the aluminum base plate as follows: the reinforcing member is sandwiched between grooves provided at the ends of the recesses of the aluminum base plate forming portions 210 of the lower mold member 202 and the upper mold member 204, and the reinforcing member can be arranged at a predetermined position (reinforcing member accommodating portion 216) of the mold member, and in this state, the molten metal can be supplied. In FIG. 3, the grooves that sandwich the reinforcing member, are formed at both ends (not shown) in a direction perpendicular to the drawing (paper surface).

The reinforcing member is not essential to the present invention. Therefore, when manufacturing an aluminum-ceramic bonded substrate in which the reinforcing member 16 is not formed inside the aluminum base plate 10, molten aluminum alloy is poured after the ceramic substrate 12 is arranged in the ceramic substrate accommodating portion 212, using the mold 200 without grooves that sandwich the reinforcing member 16.

In the method for joining an aluminum alloy and a ceramic substrate according to the present invention, it is preferable to directly bond the aluminum alloy and the ceramic substrate by a so-called molten metal bonding method. That is, when the mold is inserted into a heating furnace, heated in a non-oxidizing gas atmosphere such as nitrogen gas, and the molten aluminum alloy melted in the melting furnace is poured into the mold, it is desirable that the molten metal to be poured is in a state where an oxide film on the surface of the molten metal has been removed. Here, as a removal treatment of the oxide film, for example, it is effective to pour the molten metal while removing the oxide film on the surface of the molten metal by passing the molten metal through a very small nozzle. Further, the material of the mold is preferably a carbon material having gas permeability, for example.

As described above, an example of an embodiment of the present invention has been described. However, the present invention is not limited thereto and anything consistent with the gist of the present invention is included in the scope of the right. For example, a pin or fin for heat dissipation may be integrally formed with the aluminum base plate on the back surface of the aluminum base plate (the surface to which the ceramic substrate is not bonded), further, the reinforcing member may be omitted as a constituent member of the aluminum-ceramic bonded substrate. Further, the heat dissipation pins and fins formed integrally with the aluminum base plate can be produced by preparing a mold with a space inside that has approximately the same shape as the pin or fin, and then pouring aluminum alloy into the mold.

Examples

Hereinafter, the aluminum-ceramic bonded substrate and the method for manufacturing the same according to the present invention will be described in more detail with reference to examples. However, the present invention is not limited to the following examples.

[Example 1]

First, a ceramic substrate comprising AlN (aluminum nitride) (Vickers hardness HV is 1040) with a size of 120 mm × 92 mm × 1 mm, and a plate-like reinforcing member comprising AlN (aluminum nitride) (Vickers hardness HV is 1040) with a size of 126 mm × 94 mm × 1 mm, were placed 2.6 mm apart, and this mold was placed in a furnace, and an atmosphere in the furnace was changed to a nitrogen atmosphere to reduce an oxygen concentration to 4 ppm or less. In this state, the mold is heated to 720°C by temperature control of a heater, then, a molten aluminum alloy heated to 720°C containing 0.3% by mass of nickel, 0.02% by mass of titanium, and 0.004% by mass of boron, with a balance being aluminum and unavoidable impurities, was pressurized with nitrogen gas from a pouring nozzle attached to a pouring port of the mold, and was poured into the mold so as to fill the mold while removing the oxide film on the surface of the molten metal, then, by blowing nitrogen gas from the pouring nozzle into the pouring port, the molten metal in the mold was cooled at a cooling rate of about 20°C/min while being pressurized to solidify the molten metal, followed by cooling at a cooling rate of about 50°C/min. In addition, the formulation was adjusted so that the above alloy composition was obtained, using pure aluminum (containing at least 99.9% by mass of aluminum), a master alloy containing 20% by mass of nickel with a balance being aluminum, and a master alloy containing 5% by mass of titanium and 1% by mass of boron with a balance being aluminum, as the raw materials for the above aluminum alloy. In this way, by a so-called molten metal joining method, a metal-ceramic bonded substrate was manufactured, including an aluminum base plate with a size of 140 mm × 100 mm × 4 mm to which a reinforcing member with a size of 126 mm × 94 mm × 1 mm was placed inside and directly bonded, and including a circuit pattern aluminum plate, in which the aluminum base plate was directly bonded to one surface of a ceramic substrate with a size of 120 mm × 92 mm × 1 mm, and the circuit pattern aluminum plate with a size of 114 mm×86 mm×0.4 mm was directly bonded to the other surface of the ceramic substrate.

When viewed from above perpendicular to the ceramic substrate, both the reinforcing member and the ceramic substrate are joined to a central portion of the aluminum base plate, and the circuit pattern aluminum plate is bonded to the central portion of the ceramic substrate.

The surface of the circuit pattern aluminum plate of the aluminum-ceramic bonded substrate thus obtained was washed with caustic soda, buffed and etched with a ferric chloride solution. Then, the surface was observed with an optical microscope, and an average crystal grain size of the surface was measured according to a cutting method of JIS H0501 and found to be 0.34 mm.

The electrical resistivity of the circuit pattern aluminum plate (the aluminum alloy) of the aluminum-ceramic bonded substrate was 2.77 $\mu\Omega$·cm. The electrical resistivity was obtained by measuring the conductivity (% IACS) of the aluminum plate by an eddy current method using a conductivity meter (SIGMATEST 2.069 manufactured by FOERSTER) and converting it into electrical resistivity using the following formula.

$$\text{Electrical resistivity } (\mu\Omega \text{ cm}) = 10,000 \div (58.001 \text{ x conductivity } (\%\text{IACS}))$$

$$.....(\text{formula})$$

An aluminum-ceramic circuit board was produced by forming an aluminum circuit board having a desired circuit pattern by removing unnecessary portions of the circuit pattern aluminum plate, then, washing the surface of the circuit pattern aluminum plate of the obtained metal-ceramic bonded substrate with caustic soda followed by buffing, then, forming a resist on the surface of the circuit pattern aluminum plate, followed by etching with a ferric chloride solution, and stripping the resist with a resist stripping solution.

For the produced aluminum-ceramic circuit board, a joint between the ceramic substrate and the aluminum circuit board was observed with an ultrasonic flaw detector (SAT) (FS100II manufactured by Hitachi Kenki Finetech Co., Ltd.), and it was found that there were no unbonded parts. Then, an appearance was observed with a naked eye, and it was found that the bonding was good without bonding defects such as shrinkage cavities and intergranular cracks. Further, the cross section of the aluminum base plate was observed, and $TiB_2$ deposits were confirmed.

For the produced aluminum-ceramic circuit board, the Vickers hardness HV of the aluminum circuit board was measured by adding a test load of 10 gf for 5 seconds using a micro Vickers hardness tester (HM-210 manufactured by Mitutoyo Co., Ltd.), and the Vickers hardness HV was found to be 18.0. Further, the arithmetic mean roughness Ra was measured according to JIS B 0601 as a surface roughness of the aluminum circuit board and aluminum base plate, and they were found to be 0.43 $\mu$m and 0.55 $\mu$m, respectively.

For the produced aluminum-ceramic circuit board, the following measurement was performed at a timepoint after repeatedly adding heat cycles of -40°C x 30 minutes, 25°C x 10 minutes, 150°C x 30 minutes, and 25°C x 10 minutes as one cycle, 100 times, 200 times, 300 times, 400 times, and 500 times.

First, the electrical resistivity of the aluminum circuit board was measured in the same manner as described above, and they were found to be 2.77 $\mu\Omega$·cm, 2.76 $\mu\Omega$·cm, 2.73 $\mu\Omega$·cm, 2.75 $\mu\Omega$·cm and 2.75 $\mu\Omega$·cm, respectively.

Next, the Vickers hardness HV of the aluminum circuit board was measured in the same manner as described above, and they were found to be 19.6, 20.3, 20.7, 21.3 and 20.9 respectively.

Next, the arithmetic mean roughness Ra of the surface of the aluminum circuit board was measured in the same manner as described above, and they were found to be 0.48 $\mu$m, 0.59 $\mu$m, 0.65 $\mu$m, 0.79 $\mu$m and 0.91 $\mu$m, respectively.

Next, the arithmetic mean roughness Ra of the surface of the aluminum base plate was measured in the same manner as described above, and they were found to be 0.58 $\mu$m, 0.66 $\mu$m, 0.70 $\mu$m, 0.77 $\mu$m and 0.86 $\mu$m, respectively.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of the average grain size. In Tables 2 to 4, "HC" means heat cycle.

[Example 2]

A metal-ceramic bonded substrate was produced in the same manner as in Example 1 except that the content of nickel was 0.3% by mass, the content of titanium was 0.04% by mass, the content of boron was 0.008% by mass, with a balance being aluminum and inevitable impurities as the composition of the aluminum alloy, and an average grain size of the surface of the circuit pattern aluminum plate was measured. Further, the electrical resistivity of the circuit pattern aluminum plate of the aluminum-ceramic bonded substrate was measured in the same manner as in Example 1.

Next, a joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, in the same manner as in Example 1, the Vickers hardness HV of the aluminum circuit board, the surface arithmetic mean roughness Ra, and the surface arithmetic mean roughness Ra of the aluminum base plate were measured.

For the aluminum-ceramic circuit board thus produced, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, and 500 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Example 3]

A metal-ceramic bonded substrate was produced in the same manner as in Example 1 except that the content of nickel was 0.3% by mass, the content of iron was 0.1% by mass, the content of titanium was 0.02% by mass, the content of boron was 0.004% by mass with a balance being aluminum and unavoidable impurities, as the composition of the aluminum alloy, and an average crystal grain size of the surface of the circuit pattern aluminum plate was measured. The formulation was adjusted so that the above alloy composition was obtained, using pure aluminum (containing 99.9% by mass or more of aluminum), a master alloy containing 20% by mass of nickel with a balance being aluminum, a master alloy containing 5% by mass of titanium and 1% by mass of boron with a balance being aluminum, and a master alloy containing 75% by mass of iron with a balance being aluminum, as the raw materials for the above aluminum alloy. Further, the electrical resistivity of the circuit pattern aluminum plate of the aluminum-ceramic bonded substrate was measured in the same manner as in Example 1.

Next, a joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, when the cross section of the aluminum base plate was observed, precipitates of $TiB_2$ were confirmed.

Next, in the same manner as in Example 1, the Vickers hardness HV of the aluminum circuit board, the surface arithmetic mean roughness Ra, and the surface arithmetic mean roughness Ra of the aluminum base plate were measured.

Then, for the aluminum-ceramic circuit board thus produced, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, and 500 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Example 4]

A metal-ceramic bonded substrate was produced in the same manner as in Example 1 except that the content of nickel was 0.3% by mass, the content of iron was 0.2% by mass, the content of titanium was 0.04% by mass, the content of boron was 0.008% by mass, with a balance being aluminum and unavoidable impurities, and an average grain size of the surface of the circuit pattern aluminum plate was measured. In addition, the formulation was adjusted so that the above alloy composition was obtained, using pure aluminum (containing at least 99.9% by mass of aluminum), a master alloy containing 20% by mass of nickel with a balance being aluminum, a master alloy containing 5% by mass of titanium and 1% by mass of boron with a balance being aluminum, and a master alloy containing 75% by mass of iron with a balance being aluminum, as the raw materials for the above aluminum alloy. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, in the same manner as in Example 1, the Vickers hardness HV of the aluminum circuit board, the surface arithmetic mean roughness Ra, and the surface arithmetic mean roughness Ra of the aluminum base plate were measured.

Then, for the aluminum-ceramic circuit board thus produced, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, and 500 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Example 5]

A metal-ceramic bonded substrate was produced in the same manner as in Example 1 except that the content of nickel was 0.5% by mass, the content of titanium was 0.04% by mass, and the content of boron was 0.008% by mass, as the composition of the aluminum alloy with a balance being aluminum and unavoidable impurities, and an average grain size of the surface of the circuit pattern aluminum plate was measured. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, in the same manner as in Example 1, the Vickers hardness HV of the aluminum circuit board, the surface arithmetic mean roughness Ra, and the surface arithmetic mean roughness Ra of the aluminum base plate were measured.

Then, for the produced aluminum-ceramic circuit board, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, and 500 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Example 6]

A metal-ceramic bonded substrate was produced in the same manner as in Example 1 except that the content of Nickel was 0.5% by mass, the content of iron was 0.2% by mass, the content of titanium was 0.04% by mass, and the content of boron was 0.008% by mass with a balance being aluminum and inevitable impurities, and an average grain size of the surface of the circuit pattern aluminum plate was measured. In addition, the formulation was adjusted so that the above alloy composition was obtained, using pure aluminum (containing at least 99.9% by mass of aluminum), a master alloy containing 20% by mass of nickel with a balance being aluminum, a master alloy containing 5% by mass of titanium and 1% by mass of boron with a balance being aluminum, and a master alloy containing 75% by mass of iron with a balance being aluminum, as the raw materials for the above aluminum alloy. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, in the same manner as in Example 1, the Vickers hardness HV of the aluminum circuit board, the surface arithmetic mean roughness Ra, and the surface arithmetic mean roughness Ra of the aluminum base plate were measured.

Then, for the produced aluminum-ceramic circuit board, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, and 500 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Example 7]

A metal-ceramic bonded substrate was produced in the same manner as in Example 1 except that the content of nickel was 1.0% by mass, the content of titanium was 0.02% by mass, and the content of boron was 0.004% by mass, with a balance being aluminum and inevitable impurities, and an average grain size of the surface of the circuit pattern aluminum plate was measured. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, the Vickers hardness HV of the aluminum circuit board, the surface arithmetic mean roughness Ra, and the surface arithmetic mean roughness Ra of the aluminum base plate were measured in the same manner as in Example 1.

Then, for the produced aluminum-ceramic circuit board, the electrical resistivity and Vickers hardness HV of the aluminum circuit board were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, 500 times, 700 times, and 1000 times.

Further, for the produced aluminum-ceramic circuit board, the surface arithmetic mean roughness Ra and the surface arithmetic mean roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, 500 times, and 700 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Example 8]

A metal-ceramic bonded substrate was produced in the same manner as in Example 1 except that the content of nickel was 2.0% by mass, the content of titanium was 0.02% by mass, the content of boron was 0.004% by mass, with a balance being aluminum and inevitable impurities, as the composition of the aluminum alloy, and an average grain size of the surface of the circuit pattern aluminum plate was measured. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, the Vickers hardness HV of the aluminum circuit board, the surface arithmetic mean roughness Ra, and the surface arithmetic mean roughness Ra of the aluminum base plate were measured in the same manner as in Example 1.

Then, for the produced aluminum-ceramic circuit board, the electrical resistivity and Vickers hardness HV of the aluminum circuit board were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, 500 times, 700 times, and 1000 times.

Further, for the produced aluminum-ceramic circuit board, the surface arithmetic mean roughness Ra and the surface arithmetic mean roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, 500 times, and 700 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Example 9]

A metal-ceramic bonded substrate was produced in the same manner as in Example 1 except that the content of iron was 0.5% by mass, the content of titanium was 0.02% by mass, and the content of boron was 0.004% by mass, with a balance being aluminum and inevitable impurities, as the composition of the aluminum alloy, and an average grain size of the surface of the circuit pattern aluminum plate was measured. In addition, the formulation was adjusted so that the above alloy composition was obtained, using pure aluminum (containing at least 99.9% by mass of aluminum), a master alloy containing 5% by mass of titanium and 1% by mass of boron with a balance being aluminum, and a master alloy containing 75% by mass of iron and the balance being aluminum, as the raw materials for the above aluminum alloy. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, the Vickers hardness HV of the aluminum circuit board, the surface arithmetic mean roughness Ra, and the surface arithmetic mean roughness Ra of the aluminum base plate were measured in the same manner as in Example 1.

Then, for the produced aluminum-ceramic board, the electrical resistivity and Vickers hardness HV of the aluminum circuit board were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, 400 times, 500 times, and 700 times.

Further, for the produced aluminum-ceramic circuit board, the surface arithmetic mean roughness Ra and the surface arithmetic mean roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 200 times, 300 times, and 400 times.

As described above, Table 1 shows the composition of the aluminum alloy used for the aluminum-ceramic bonded substrate according to this example, Table 2 shows measured values of electrical resistivity, Table 3 shows measured values of Vickers hardness HV, Table 4 shows measured values of arithmetic mean roughness Ra, and Table 5 shows measured values of average grain size.

[Comparative Example 1]

A metal-ceramic bonded substrate was produced in the same manner as in Example 1 except that the content of silicon was 0.4% by mass, the content of boron was 0.04% by mass, the content of iron was 0.01% by mass, with a balance being aluminum and inevitable impurities, as the composition of the aluminum alloy, and an average grain size of the surface of the circuit pattern aluminum plate was measured. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding.

Next, the Vickers hardness HV of the aluminum circuit board, the surface arithmetic mean roughness Ra, and the surface arithmetic mean roughness Ra of the aluminum base plate were measured in the same manner as in Example 1.

Then, for the produced aluminum-ceramic circuit board, the surface arithmetic mean roughness Ra and the surface arithmetic mean roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 1000 times.

As described above, Table 1 shows the composition of the aluminum alloy used for the aluminum-ceramic bonded substrate according to this comparative example, Table 2 shows measured values of electrical resistivity, Table 3 shows measured values of Vickers hardness HV, Table 4 shows measured values of arithmetic mean roughness Ra, and Table 5 shows measured values of average grain size.

[Comparative Example 2]

A metal-ceramic bonded substrate was produced in the same manner as in Example 1 except that the content of titanium was 0.02% by mass, the content of boron was 0.004% by mass, with a balance being aluminum and inevitable impurities, as the composition of the aluminum alloy. In addition, the formulation was adjusted so that the above alloy composition was obtained, using pure aluminum (containing at least 99.9% by mass of aluminum), a master alloy containing 5% by mass of titanium and 1% by mass of boron with a balance being aluminum, as the raw materials for the above aluminum alloy. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, in the same manner as in Example 1, the Vickers hardness HV of the aluminum circuit board, the surface arithmetic mean roughness Ra, and the surface arithmetic mean roughness Ra of the aluminum base plate were measured.

Then, for the produced aluminum-ceramic circuit board, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 300 times, 500 times, and 1000 times.

As described above, Table 1 shows the composition of the aluminum alloy used for the aluminum-ceramic bonded substrate according to this comparative example, Table 2 shows measured values of electrical resistivity, Table 3 shows measured values of Vickers hardness HV, Table 4 shows measured values of arithmetic mean roughness Ra, and Table 5 shows measured values of average grain size.

[Comparative Example 3]

A metal-ceramic bonded substrate was produced in the same manner as in Example 1 except that the content of titanium was 0.04% by mass, and the content of boron was 0.008% by mass, with a balance being aluminum and inevitable impurities, as the composition of the aluminum alloy, and the average crystal grain size of the surface of the circuit pattern aluminum plate was measured. In addition, the formulation was adjusted so that the above alloy composition was obtained, using pure aluminum (containing at least 99.9% by mass of aluminum), and a master alloy containing 5% by mass of titanium and 1% by mass of boron with a balance being aluminum, as the raw materials for the above aluminum alloy. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, in the same manner as in Example 1, the Vickers hardness HV of the aluminum circuit board, the surface arithmetic mean roughness Ra, and the surface arithmetic mean roughness Ra of the aluminum base plate were measured.

Then, for the aluminum-ceramic circuit board, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 300 times, and 500 times, and 1000 times.

As described above, Table 1 shows the composition of the aluminum alloy used for the aluminum-ceramic bonded substrate according to this comparative example, Table 2 shows measured values of electrical resistivity, Table 3 shows measured values of Vickers hardness HV, Table 4 shows measured values of arithmetic mean roughness Ra, and Table 5 shows measured values of average grain size.

[Comparative Example 4]

A metal-ceramic bonded substrate was produced in the same manner as in Example 1 except that the content of titanium was 0.1% by mass, the content of boron was 0.02% by mass, with a balance being aluminum and inevitable impurities, as the composition of the aluminum alloy, and an average grain size of the surface of the circuit pattern aluminum plate was measured. In addition, the formulation was adjusted so that the above alloy composition was obtained, using pure aluminum (containing at least 99.9% by mass of aluminum), and a master alloy containing 5% by mass of titanium and 1% by mass of boron with a balance being aluminum, as the raw materials for the above aluminum alloy. Further, the electrical resistivity of the circuit pattern aluminum plate of the aluminum-ceramic bonded substrate was measured in the same manner as in Example 1.

Further, the joint between the ceramic substrate and the aluminum circuit board was observed in the same manner as in Example 1, and it was found that there were no unbonded parts, and there were no bonding defects such as shrinkage cavities or intergranular cracks, indicating good bonding. Further, the cross section of the aluminum base plate was observed, and $TiB_2$ deposits were confirmed.

Next, the Vickers hardness HV of the aluminum circuit board, the surface arithmetic mean roughness Ra, and the surface arithmetic mean roughness Ra of the aluminum base plate were measured in the same manner as in Example 1.

Then, for the produced aluminum-ceramic circuit board, the electrical resistivity, Vickers hardness HV, surface arithmetic mean roughness Ra of the aluminum circuit board, and arithmetic mean surface roughness Ra of the aluminum base plate were measured in the same manner as described above, after repeatedly adding heat cycles of -40°C × 30 minutes, 25°C × 10 minutes, 150°C × 30 minutes, and 25°C × 10 minutes as one cycle, 100 times, 300 times, and 500 times, and 1000 times.

As described above, Table 1 shows the composition of the aluminum alloy used for the aluminum-ceramic bonded substrate according to this comparative example, Table 2 shows measured values of electrical resistivity, Table 3 shows measured values of Vickers hardness HV, Table 4 shows measured values of arithmetic mean roughness Ra, and Table 5 shows measured values of average grain size.

[Table 1]

|  | Ni (mass%) | Fe (mass%) | Ti (mass%) | Si (mass%) | B (mass%) | Al (mass%) |
|---|---|---|---|---|---|---|
| Example 1 | 0.3 |  | 0.02 |  | 0.004 | Balance |
| Example 2 | 0.3 |  | 0.04 |  | 0.008 | Balance |
| Example 3 | 0.3 | 0.1 | 0.02 |  | 0.004 | Balance |
| Example 4 | 0.3 | 0.2 | 0.04 |  | 0.008 | Balance |
| Example 5 | 0.5 |  | 0.04 |  | 0.008 | Balance |
| Example 6 | 0.5 | 0.2 | 0.04 |  | 0.008 | Balance |
| Example 7 | 1.0 |  | 0.02 |  | 0.004 | Balance |
| Example 8 | 2.0 |  | 0.02 |  | 0.004 | Balance |
| Example 9 |  | 0.5 | 0.02 |  | 0.004 | Balance |
| Com.Ex. 1 |  | 0.01 |  | 0.4 | 0.04 | Balance |
| Com.Ex. 2 |  |  | 0.02 |  | 0.004 | Balance |
| Com.Ex. 3 |  |  | 0.04 |  | 0.008 | Balance |
| Com.Ex. 4 |  |  | 0.10 |  | 0.02 | Balance |
| * Com.Ex. = Comparative Example | | | | | | |

[Table 2]

|  | Initial stage (μΩ·cm) | HC100 (μΩ·cm) | HC200 (μΩ·cm) | HC300 (μΩ·cm) | HC400 (μΩ·cm) | HC500 (μΩ·cm) | HC700 (μΩ·cm) | HC1000 (μΩ·cm) |
|---|---|---|---|---|---|---|---|---|
| Example 1 | 2.77 | 2.77 | 2.76 | 2.73 | 2.75 | 2.75 |  |  |
| Example 2 | 2.83 | 2.82 | 2.82 | 2.81 | 2.81 | 2.83 |  |  |
| Example 3 | 2.77 | 2.78 | 2.74 | 2.76 | 2.76 | 2.77 |  |  |

(continued)

|  | Initial stage | HC100 | HC200 | HC300 | HC400 | HC500 | HC700 | HC1000 |
|---|---|---|---|---|---|---|---|---|
|  | ($\mu\Omega\cdot$cm) | ($\mu\Omega\cdot$cm) | ($\mu\Omega\cdot$cm) | ($\mu\Omega\cdot$cm) | ($\mu\Omega\cdot$cm) | ($\mu\Omega\cdot$cm) | ($\mu\Omega\cdot$cm) | ($\mu\Omega\cdot$cm) |
| Example 4 | 2.86 | 2.87 | 2.86 | 2.86 | 2.86 | 2.86 |  |  |
| Example 5 | 2.83 | 2.85 | 2.83 | 2.84 | 2.85 | 2.85 |  |  |
| Example 6 | 2.88 | 2.9 | 2.88 | 2.88 | 2.89 | 2.88 |  |  |
| Example 7 | 2.79 | 2.8 | 2.78 | 2.8 | 2.8 | 2.76 | 2.79 | 2.78 |
| Example 8 | 2.82 | 2.82 | 2.82 | 2.84 | 2.83 | 2.82 | 2.83 | 2.82 |
| Example 9 | 2.82 | 2.88 | 2.85 | 2.84 | 2.84 | 2.85 | 2.83 |  |
| Com.Ex. 1 | 2.98 |  |  |  |  |  |  |  |
| Com.Ex. 2 | 2.66 | 2.70 |  | 2.72 |  | 2.70 |  | 2.70 |
| Com.Ex. 3 | 2.72 | 2.73 |  | 2.75 |  | 2.74 |  | 2.77 |
| Com.Ex. 4 | 2.97 | 2.98 |  | 3.01 |  | 3.00 |  | 3.01 |
| * Com.Ex. = Comparative Example |

[Table 3]

|  | Initial stage | HC100 | HC200 | HC300 | HC400 | HC500 | HC700 | HC1000 |
|---|---|---|---|---|---|---|---|---|
|  | (HV) | (HV) | (HV) | (HV) | (HV) | (HV) | (HV) | (HV) |
| Example 1 | 18.02 | 19.6 | 20.3 | 20.7 | 21.3 | 20.9 |  |  |
| Example 2 | 18.66 | 20.3 | 20.3 | 20.8 | 21 | 21.3 |  |  |
| Example 3 | 18.6 | 20.3 | 20.2 | 21.1 | 21.3 | 21.6 |  |  |
| Example 4 | 19.2 | 20.4 | 20.6 | 21.1 | 21 | 21.3 |  |  |
| Example 5 | 19.7 | 20.7 | 20.7 | 21.3 | 21.8 | 22.1 |  |  |
| Example 6 | 20.75 | 22 | 22.1 | 22.5 | 22.9 | 23.1 |  |  |
| Example 7 | 20.1 | 22.7 | 21.6 | 21.9 | 25 | 23.5 | 22.9 | 23 |
| Example 8 | 23.7 | 28.8 | 25.3 | 25.2 | 28 | 26.5 | 25.8 | 26.9 |
| Example 9 | 19.7 | 20.4 | 20.2 | 20.8 | 21.4 | 20.3 | 21.4 |  |
| Com.Ex. 1 | 20.6 |  |  |  |  |  |  |  |
| Com.Ex. 2 | 14.6 | 15.4 |  | 15.7 |  | 16 |  | 16.1 |
| Com.Ex. 3 | 14.9 | 15.9 |  | 16.1 |  | 16.5 |  | 16.4 |
| Com.Ex. 4 | 16.3 | 17.5 |  | 17.8 |  | 17.9 |  | 18.7 |
| * Com.Ex. = Comparative Example |

[Table 4]

|  |  | Initial stage | HC100 | HC200 | HC300 | HC400 | HC500 | HC700 | HC1000 |
|---|---|---|---|---|---|---|---|---|---|
|  |  | ($\mu$m) | ($\mu$m) | ($\mu$m) | ($\mu$m) | ($\mu$m) | ($\mu$m) | ($\mu$m) | ($\mu$m) |
| Example 1 | Circuit board | 0.4303 | 0.4833 | 0.587 | 0.653 | 0.785 | 0.909 |  |  |
|  | Base plate | 0.5457 | 0.5763 | 0.661 | 0.701 | 0.77 | 0.863 |  |  |

(continued)

|  | | Initial stage | HC100 | HC200 | HC300 | HC400 | HC500 | HC700 | HC1000 |
|---|---|---|---|---|---|---|---|---|---|
|  | | (μm) | (μm) | (μm) | (μm) | (μm) | (μm) | (μm) | (μm) |
| Example 2 | Circuit board | 0.3617 | 0.4057 | 0.4863 | 0.547 | 0.647 | 0.748 | | |
|  | Base plate | 0.338 | 0.414 | 0.514 | 0.575 | 0.652 | 0.702 | | |
| Example 3 | Circuit board | 0.3967 | 0.456 | 0.3571 | 0.64 | 0.671 | 0.758 | | |
|  | Base plate | 0.4323 | 0.458 | 0.556 | 0.605 | 0.687 | 0.807 | | |
| Example 4 | Circuit board | 0.3497 | 0.371 | 0.4357 | 0 .45.7 | 0.55 | 0.569 | | |
|  | Base plate | 0.41 | 0.4127 | 0.47 | 0.516 | 0.545 | 0.603 | | |
| Example 5 | Circuit board | 0.335 | 0.396 | 0.426 | 0.501 | 0.602 | 0.689 | | |
|  | Base plate | 0.3823 | 0.3787 | 0.4663 | 0.561 | 0.616 | 0.669 | | |
| Example 6 | Circuit board | 0.3313 | 0.3627 | 0.3923 | 0.446 | 0.515 | 0.566 | | |
|  | Base plate | 0.377 | 0.3707 | 0.4103 | 0.478 | 0.522 | 0.574 | | |
| Example 7 | Circuit board | 0.551 | 0.542 | 0.634 | 0.678 | 0.724 | 0.754 | 0.9 | |
|  | Base plate | 1.24 | 1.139 | 1.165 | 1.065 | 1.174 | 1.188 | 1.273 | |
| Example 8 | Circuit board | 0.573 | 0.549 | 0.582 | 0.629 | 0.677 | 0.656 | 0.726 | |
|  | Base plate | 1.262 | 1.218 | 1.254 | 1.302 | 1.225 | 1.27 | 1.32 | |
| Example 9 | Circuit board | 0.895 | 0.913 | 0.935 | 0.914 | 0.976 | | | |
|  | Base plate | 1.456 | 1.471 | 1.413 | 1.457 | 1.494 | | | |
| Com.Ex. 1 | Circuit board | 0.49 | | | | | | | 2.593 |
|  | Base plate | 1.257 | | | | | | | 3.15 |
| Com.Ex. 2 | Circuit board | 0.742 | 0.779 | | 1.178 | | 1.474 | | 2.254 |
|  | Base plate | 1.72 | 1.371 | | 1.655 | | 1.995 | | 2.85,8 |
| Com.Ex. 3 | Circuit board | 0.646 | 0.689 | | 1.079 | | 1.375 | | 2.15 |
|  | Base plate | 1.43 | 1.247 | | 1.47 | | 1.654 | | 2.53.5 |
| Com.Ex.4 | Circuit board | 0.55 | 0.543 | | 0.818 | | 1.002 | | 1.55 |
|  | Base plate | 0.987 | 0.89 | | 1.079 | | 1.238 | | 1.76 |
| * Com.Ex. = Comparative Example | | | | | | | | | |

[Table5]

|  | Initial stage |
|---|---|
|  | (mm) |
| Example 1 | 0.34 |
| Example 2 | 0.2 |
| Example 3 | 0.29 |
| Example 4 | 022 |
| Example 5 | 018 |
| Example 6 | 0.2 |
| Example 7 | 0.4 |
| Example 8 | 0.4 |
| Example 9 | 0.4 |
| Corn Ex. 1 | 1.5 |

(continued)

|  | Initial stage |
| --- | --- |
|  | (mm) |
| Com.Ex. 2 | 0.39 |
| Com.Ex. 3 | 0.3 |
| Com.Ex. 4 | 0.1 |
| * Com.Ex. = Comparative Example | |

Description of Signs and Numerals

| 10 | Aluminum plate |
| 12 | Ceramic substrate |
| 14 | Circuit pattern aluminum plate |
| 16 | Reinforcing member |
| 100 | Aluminum-ceramic bonded substrate |
| 200 | Mold |
| 202 | Lower mold member |
| 204 | Upper mold member |
| 210 | Aluminum base plate forming portion |
| 212 | Substrate accommodation portion |
| 214 | Aluminum plate forming portion |
| 216 | Reinforcing member accommodating portion |

## Claims

1. An aluminum-ceramic bonded substrate in which an aluminum plate comprising aluminum alloy is directly bonded to one surface of a ceramic substrate and an aluminum base plate comprising aluminum alloy is directly bonded to the other surface of the ceramic substrate,
   wherein the aluminum alloy is the aluminum alloy containing 0.05% by mass or more and 3.0% by mass or less of at least one element selected from nickel and iron in total amount, containing 0.01% by mass or more and 0.1% by mass or less of at least one element selected from titanium and zirconium in total amount, and containing 0% by mass or more and 0.05% by mass or less of at least one element selected from boron or carbon in total amount, with a balance being aluminum.

2. The aluminum-ceramic bonded substrate according to claim 1, wherein the aluminum plate has a Vickers hardness HV of 17 or more.

3. The aluminum-ceramic bonded substrate according to claim 1 or 2, wherein the aluminum plate has a Vickers hardness HV of less than 25.

4. The aluminum-ceramic bonded substrate according to any one of claims 1 to 3, wherein an average crystal grain size in a surface of the aluminum plate is 600 $\mu$m or less.

5. The aluminum-ceramic bonded substrate according to any one of claims 1 to 4, wherein the surface of the aluminum plate has an arithmetic mean roughness Ra of 1.0 $\mu$m or less.

6. The aluminum-ceramic bonded substrate according to any one of claims 1 to 5, wherein the aluminum plate has an electrical resistivity of 3.2 $\mu\Omega\cdot$cm or less.

7. The aluminum-ceramic bonded substrate according to any one of claims 1 to 6, wherein a main component of the ceramic substrate is one or more selected from alumina, aluminum nitride, silicon nitride and silicon carbide.

8. The aluminum-ceramic bonded substrate according to any one of claims 1 to 7, wherein a plate-like reinforcing member having hardness greater than that of the aluminum base plate is arranged inside the aluminum base plate and directly bonded to the aluminum base plate.

9. A method for manufacturing an aluminum-ceramic bonded substrate, comprising:

placing a ceramic substrate in a mold, and pouring molten aluminum alloy into the mold so as to be in contact with both sides of the ceramic substrate, followed by cooling and thereby,
forming an aluminum plate comprising the aluminum alloy on one surface of the ceramic substrate and directly bonding it to the ceramic substrate; and
forming an aluminum base plate comprising the aluminum alloy on the other surface of the ceramic substrate and directly bonding it to the ceramic sub strate,
wherein the aluminum alloy is the aluminum alloy containing 0.05% by mass or more and 3.0% by mass or less of at least one element selected from nickel or iron in total amount, containing 0.01% by mass or more and 0.1% by mass or less of at least one element selected from titanium or zirconium in total amount, and containing 0% by mass or more and 0.05% by mass or less at least one element selected from boron or carbon in total amount, with a balance being aluminum.

10. The method for manufacturing an aluminum-ceramic bonded substrate according to claim 9, wherein a main component of the ceramic substrate is one or more selected from alumina, aluminum nitride, silicon nitride and silicon carbide.

11. The method for manufacturing an aluminum-ceramic bonded substrate according to claim 9 or 10, comprising:

placing a plate-like reinforcing member in the mold at a distance from the ceramic substrate, pouring the molten aluminum alloy into the mold so as to be in contact with both surfaces of the ceramic substrate in the mold and a surface of the reinforcing member, followed by cooling and thereby,
forming the aluminum plate comprising the aluminum alloy on one surface of the ceramic substrate and directly bonding it to the ceramic substrate;
forming the aluminum base plate comprising the aluminum alloy on the other surface of the ceramic substrate and directly bonding it to the ceramic substrate; and
placing the reinforcing member inside the aluminum base plate and directly bonding it to the aluminum base plate.

## FIG. 1

**100**

10: Aluminum base plate
12: Ceramic substrate
14: Circuit pattern aluminum plate
100: Aluminum-ceramic bonded substrate

# FIG. 2

10: Aluminum base plate
12: Ceramic substrate
14: Circuit pattern aluminum plate
16: Reinforcing member

# FIG. 3

200: Mold
202: Lower mold member
204: Upper mold member
210: Aluminum base plate forming portion
212: Ceramic substrate accommodating portion
214: Aluminum plate forming portion
216: Reinforcing member accommodating portion

## INTERNATIONAL SEARCH REPORT

| International application No. |
| --- |
| **PCT/JP2021/045567** |

### A. CLASSIFICATION OF SUBJECT MATTER

*H05K 1/09*(2006.01)i; *B22D 19/00*(2006.01)i; *C04B 37/02*(2006.01)i; *C22C 21/00*(2006.01)i; *H01L 23/14*(2006.01)i; *H05K 1/02*(2006.01)i
FI: H05K1/09 A; C22C21/00 A; B22D19/00 E; C04B37/02 B; H05K1/02 F; H01L23/14 M

According to International Patent Classification (IPC) or to both national classification and IPC

### B. FIELDS SEARCHED

Minimum documentation searched (classification system followed by classification symbols)
H05K1/09; B22D19/00; C04B37/02; C22C21/00; H01L23/14; H05K1/02

Documentation searched other than minimum documentation to the extent that such documents are included in the fields searched
Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2005-103560 A (DOWA MINING CO LTD) 21 April 2005 (2005-04-21) paragraphs [0008], [0011], [0026]-[0027], [0034] | 1-11 |
| A | WO 2007/072700 A1 (SHOWA DENKO KK) 28 June 2007 (2007-06-28) paragraphs [0008]-[0010], [0040] | 1-11 |
| A | JP 2003-243803 A (HITACHI LTD) 29 August 2003 (2003-08-29) paragraphs [0060], [0115] | 1-11 |
| A | JP 2020-161707 A (DOWA METALTECH KK) 01 October 2020 (2020-10-01) paragraph [0032] | 1-11 |
| A | WO 2018/131583 A1 (MITSUBISHI ELECTRIC CORP) 19 July 2018 (2018-07-19) paragraphs [0017]-[0029], fig. 2-3 | 1-11 |
| A | JP 2019-141879 A (DOWA METALTECH KK) 29 August 2019 (2019-08-29) paragraphs [0030]-[0039] | 1-11 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **17 February 2022** | **01 March 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**EP 4 319 503 A1**

| INTERNATIONAL SEARCH REPORT | | International application No. |
| Information on patent family members | | PCT/JP2021/045567 |

| Patent document cited in search report | | | Publication date (day/month/year) | Patent family member(s) | Publication date (day/month/year) |
|---|---|---|---|---|---|
| JP | 2005-103560 | A | 21 April 2005 | US 2005/0072547 A1 paragraphs [0016], [0019], [0042]-[0043], [0050] EP 1518847 A2 | |
| WO | 2007/072700 | A1 | 28 June 2007 | US 2009/0174063 A1 paragraphs [0020]-[0023], [0056] EP 1970955 A1 CN 101341592 A KR 10-2008-0077251 A | |
| JP | 2003-243803 | A | 29 August 2003 | (Family: none) | |
| JP | 2020-161707 | A | 01 October 2020 | (Family: none) | |
| WO | 2018/131583 | A1 | 19 July 2018 | US 2019/0350078 A1 paragraphs [0027]-[0040], fig. 2-3 CN 110169211 A | |
| JP | 2019-141879 | A | 29 August 2019 | (Family: none) | |

**EP 4 319 503 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005252136 A
- JP 2007092150 A
- JP 2002329814 A
- JP 2005103560 A